# EUROPEAN PATENT APPLICATION

(11) **EP 4 354 175 A1**
(43) Date of publication of application: **17.04.2024**
(21) Application number: 22819135.9
(22) Date of filing: 17.03.2022
(51) Int. Cl.: G01S 7/481, G01S 17/08

(54) **CONTROL METHOD FOR LIDAR, AND LIDAR**

(30) Priority: 07.06.2021 CN 202110631357
(71) Applicant: Hesai Technology Co., Ltd., Shanghai 201821 (CN)
(72) Inventor: SUN, Kai, Shanghai 201821 (CN); XIANG, Shaoqing, Shanghai 201821 (CN)
(74) Representative: Appelt, Christian W.
(86) International application number: PCT/CN2022/081305
(87) International publication number: WO 2022/257530

(57) **Abstract**

The present disclosure provides a control method for a LiDAR, comprising: S101: transmitting a laser pulse signal based on a pulse coding and a current energy allocation scheme to detect a target object, the laser pulse signal comprising a plurality of laser pulses adopting the pulse coding; S102: receiving echo information of the plurality of laser pulses reflected by the target object; and S103: updating, based on the echo information of the target object, the energy allocation scheme adopted by the LiDAR for the next transmission. A preferred embodiment of the present disclosure not only satisfies the anti-crosstalk demand within a short range, but also improves the detection precision and detection performance within a long range, and a maximally beneficial application of laser pulse energy is obtained while safety requirements for human eye are met.

## Description

### TECHNICAL FIELD

The present disclosure generally relates to the technical field of laser detection, in particular to a control method for a LiDAR, and a LiDAR.

### BACKGROUND

A LiDAR is used for ranging typically based on the method of direct time-of-flight (TOF), which performs ranging by transmitting a laser pulse narrow in bandwidth but high in peak power and measuring the TOF of the laser pulse between the LiDAR and a target object.

Within the same measurement range, when there are multiple LiDARs operating simultaneously in a scenario, for example, when multiple LiDARs are installed on one vehicle, or when multiple vehicles equipped with a LiDAR are relatively close to one another, because the measurement principle of LiDAR is based on measuring the TOF of a transmitted laser pulse, if each LiDAR cannot distinguish whether a received echo pulse was transmitted by itself, then there is a certain probability that the received echo pulses transmitted by other LiDARs may also be determined as its own echo signals, thereby leading to errors in the ranging results, i.e. crosstalk may occur. When multiple LiDARs operate simultaneously, the problem of mutual interference among different LiDARs has become one of the bottlenecks limiting the development.

Currently, adopting multi-pulse coding to identify an echo signal is an effective anti-interference solution for LiDAR. However, adopting the pulse coding may affect the long-range detection performance of LiDAR.

This is because the energy of each pulse transmitted by a LiDAR is limited by the range required for human eye safety. That is, the energy of each transmitted pulse cannot be increased unlimitedly, and needs to be lower than a safety threshold for human eye.

For example, according to the National Standards of the People's Republic of China for Safety of Laser Products - Part 14: A User's Guide, lasers are divided into four major classes in China: Class 1: laser products, of which laser radiation shall not exceed a threshold of Class 1 at a respective wavelength and within the transmission duration; Class 1M: laser products, which have a wavelength in the range of 0.3-4 µm, and have an energy threshold not exceeding that of Class 1, and which adopt a smaller measurement aperture; Class 2: laser products, of which laser radiation shall not exceed a threshold of Class 2 at a respective wavelength and within the transmission duration; Class 2M: laser products, which have a wavelength in the range of 0.7-1.4 µm, has an energy threshold not exceeding that of Class 2, and which adopt a smaller measurement aperture or which are evaluated at a farther distance; Classes 3R and 3B: laser products, of which an energy threshold is allowed to exceed those of Classes 1 and 2, but shall not exceed respective energy thresholds of 3R and 3B within any wavelength range; and Class 4: laser products, with which people may contact and are likely to exceed the transmission limit of Class 3B.

During practical application processes, in the event of direct illumination to human eye, laser will cause damage to human eye, and thus there are strict requirements for the selection of lasers. Typically, the wavelength of a laser is set between 0.7 and 1.4 µm. Based on the classification in the Guide, the maximum limit for the safety to the naked eye is Class 3R. Taking a wavelength of 905 nm as an example, assuming that an illumination duration t equals to 10 seconds and a pulse repetition frequency f is 8.8 kHz, then the number N of pulses within this time is 8×10⁴, and the maximum permissible exposure MPEₘₐₓ to the cornea is 2601.4 J/m². Based on the equation MPE_{average}=MPEₘₐₓ/N, an exposure MPE_{average} for a single pulse is calculated to be 0.033 J/m². If a consecutive pulse is adopted, a resulting consecutive pulse MPEₜᵣₐᵢₙ is 1.962 µJ/m².

Moreover, based on international standards, in the case of a specified irradiation angle, a laser wavelength affects the maximum permissible exposure of a single pulse; at the same irradiation time, as the frequency of a transmitted pulse increases, the maximum permissible exposure of consecutive pulses decreases accordingly; in the case of the same laser repetition frequency, as the irradiation time increases, the maximum permissible exposure of the consecutive pulses also decreases; and the energy of a single pulse is lower than that of consecutive pulses. That is, the maximum allowable irradiation energy of a laser is determined by the wavelength, repetition frequency, irradiation angle, and irradiation time together.

Under the constraints of the above-mentioned safety requirements for human eye, the greater the number of pulses transmitted by a LiDAR in each detection, the less energy is allocated to each pulse, and the shorter the detectable distance. If only a single pulse is transmitted in each detection, then the anti-crosstalk problem cannot be effectively solved, which will greatly affect the quality of the point cloud of the LiDAR. In the background where multi-pulse coding technology is adopted, it is an urgent technical problem in the art to satisfy both the long-range detection capability of LiDAR and the safety requirements for human eye.

The content in the Background Art merely involves the technology known by the disclosers and does not necessarily represent the prior art in the field.

### SUMMARY

In view of at least one of the drawbacks in the existing art, the present disclosure provides a control method for a LiDAR, comprising:
S101: transmitting a laser pulse signal based on a pulse coding and a current energy allocation scheme, to detect a target object, the laser pulse signal comprising a plurality of laser pulses adopting the pulse coding;
S102: receiving echo information of the plurality of laser pulses reflected by the target object; and
S103: updating, based on the echo information of the target object, the energy allocation scheme adopted by the LiDAR for the next transmission.

According to an aspect of the present disclosure, a sum of the energy of the plurality of laser pulses is less than a first energy threshold, the first energy threshold being determined based on the requirement that the total energy of pulses transmitted within a predetermined time is less than a safety threshold for human eye.

According to an aspect of the present disclosure, the plurality of laser pulses comprises at least one long-range detection pulse and at least one short-range detection pulse, the step S103 further comprising:
determining a ranging condition based on the echo information of the target object, and increasing the energy of the long-range detection pulse when the ranging condition is a long-range detection condition.

According to an aspect of the present disclosure, the step S103 further comprises:
increasing the energy of the long-range detection pulse while decreasing the energy of the short-range detection pulse when the ranging condition is the long-range detection condition, the energy of the short-range detection pulse being greater than a second energy threshold.

According to an aspect of the present disclosure, the long-range detection condition includes the target object being located beyond a first distance range, and the second energy threshold is determined based on the detection demand for a second distance range, the second distance range being less than or equal to the first distance range.

According to an aspect of the present disclosure, when the ranging condition is the long-range detection condition, the energy of the long-range detection pulse is increased stepwise for each detection until the sum of the energy of the plurality of laser pulses approaches the first energy threshold.

According to an aspect of the present disclosure, when the ranging condition is the long-range detection condition, the energy of the long-range detection pulse is increased for the next detection, so that the sum of the energy of the plurality of laser pulses approaches the first energy threshold, and the energy of the short-range detection pulse approaches the second energy threshold.

According to an aspect of the present disclosure, the plurality of laser pulses comprises at least one long-range detection pulse and at least one short-range detection pulse, the step S 103 further comprising:
determining a ranging condition based on the echo information of the target object, and decreasing the energy of the long-range detection pulse while increasing the energy of the short-range detection pulse when the ranging condition is a short-range detection condition, the energy of the short-range detection pulse being less than or equal to the energy of the long-range detection pulse in the same transmission.

According to an aspect of the present disclosure, when the ranging condition is the short-range detection condition, the long-range detection pulse and the short-range detection pulse similar in energy are transmitted during the next detection, and the sum of the energy of the plurality of laser pulses is controlled to approach the first energy threshold.

According to an aspect of the present disclosure, the control method further comprises:
adjusting the peak intensities or pulse widths of the plurality of laser pulses by adjusting the energy allocation of the plurality of laser pulses for the next transmission of the LiDAR.

According to an aspect of the present disclosure, the control method further comprises:
increasing the pulse peaks of the plurality of laser pulses by increasing the maximum driving current/voltage of the plurality of laser pulses.

According to an aspect of the present disclosure, the control method further comprises:
maintaining the driving current/voltage constant, and extending/shortening the pulse widths of the plurality of laser pulses by extending/shortening the transmission time of the plurality of laser pulses.

According to an aspect of the present disclosure, the control method further comprises:
calculating a distance from the target object based on the echo information corresponding to the plurality of laser pulses.

The present disclosure also provides a LiDAR, comprising:
a transmitter unit configure to transmit a laser pulse signal based on a pulse coding and a current energy allocation scheme, to detect a target object, the laser pulse signal comprising a plurality of laser pulses adopting the pulse coding;
a receiver unit configured to receive echo information of the plurality of laser pulses reflected by the target object; and
a controller unit configured to update, based on the echo information of the target object, the energy allocation scheme adopted by the LiDAR for the next transmission.

According to an aspect of the present disclosure, a sum of the energy of the plurality of laser pulses is less than a first energy threshold, the first energy threshold being determined based on the requirement that the total energy of pulses transmitted within a predetermined time is less than a safety threshold for human eye.

According to an aspect of the present disclosure, the plurality of laser pulses comprises at least one long-range detection pulse and at least one short-range detection pulse, and the controller unit is further configured to:
determine a ranging condition based on the echo information of the target object, and increase the energy of the long-range detection pulse when the ranging condition is a long-range detection condition.

According to an aspect of the present disclosure, the controller unit is further configured to:
increase the energy of the long-range detection pulse while decrease the energy of the short-range detection pulse when the ranging condition is the long-range detection condition, the energy of the short-range detection pulse being greater than a second energy threshold.

According to an aspect of the present disclosure, the long-range detection condition includes the target object being located beyond a first distance range, and the second energy threshold is determined based on the detection demand for a second distance range, the second distance range being less than or equal to the first distance range.

According to an aspect of the present disclosure, the transmitter unit comprises at least one laser, and the LiDAR further comprises:
a first energy regulator unit coupled with the at least one laser and the controller unit, and configured to regulate the driving current/voltage of the at least one laser under the control of the controller unit to adjust the pulse peaks of the plurality of laser pulses for the next transmission of the LiDAR.

According to an aspect of the present disclosure, the transmitter unit comprises at least one laser, and the LiDAR further comprises:
a second energy regulator unit coupled with the at least one laser and the controller unit, and configured to regulate a transmission time of the at least one laser under the control of the controller unit to adjust the pulse widths of the plurality of laser pulses for the next transmission of the LiDAR.

A preferred embodiment of the present disclosure provides a control method for a LiDAR, comprising: transmitting a plurality of laser pulses encoded by time interval and adjusting the energy allocation of the plurality of laser pulses for the next transmission based on echo information of a target object. The preferred embodiment of the present disclosure not only satisfies the anti-crosstalk demand within a short range, but also improves the detection precision and detection performance within a long range, and a maximally beneficial application of laser pulse energy is obtained while safety requirements for human eye are met.

### BRIEF DESCRIPTION OF THE DRAWINGS

The drawings that constitute part of the specification are provided for further understanding the present disclosure, which, along with the embodiments of the present disclosure, are used for explaining the present disclosure, and do not make any improper limitation of the same. In the drawings:
FIG. 1 shows a control method for a LiDAR according to one preferred embodiment of the present disclosure;
FIG. 2 schematically shows a curve of change of a safe laser power for human eye over time;
FIG. 3 schematically shows a transmitted pulse sequence of a LiDAR and its echo pulse sequence;
FIG. 4 schematically shows a transmitted pulse sequence of a LiDAR and an echo pulse sequence received from other LiDARs;
FIG. 5A schematically shows transmission of at least one short-range detection pulse and at least one long-range detection pulse according to one preferred embodiment of the present disclosure;
FIG. 5B schematically shows transmission of at least one short-range detection pulse and at least one long-range detection pulse according to one preferred embodiment of the present disclosure;
FIG. 6 schematically shows echoes of at least one short-range detection pulse and at least one long-range detection pulse within different distance ranges according to one preferred embodiment of the present disclosure;
FIG. 7A schematically shows transmission of at least one short-range detection pulse and at least one long-range detection pulse the same or similar in pulse width but different in peak power according to one preferred embodiment of the present disclosure;
FIG. 7B schematically shows transmission of at least one short-range detection pulse and at least one long-range detection pulse the same or similar in peak power but different in pulse width according to one preferred embodiment of the present disclosure;
FIG. 8 schematically shows a driving circuit of a laser according to one preferred embodiment of the present disclosure;
FIG. 9A schematically shows a driving circuit of a laser according to another preferred embodiment of the present disclosure;
FIG. 9B shows time sequence changes of various nodes in the driving circuit of FIG. 9A;
FIG. 10 schematically shows an energy regulation circuit according to one preferred embodiment of the present disclosure;
FIG. 11 schematically shows a laser pulse signal triggered by switch control signals according to one preferred embodiment of the present disclosure;
FIG. 12A schematically shows dual pulses with an coding as triggered by switch control signals according to one preferred embodiment of the present disclosure;
FIG. 12B schematically shows dual pulses with another coding as triggered by switch control signals according to one preferred embodiment of the present disclosure; and
FIG. 13 schematically shows a LiDAR according to one preferred embodiment of the present disclosure.

### DETAILED DESCRIPTION OF THE EMBODIMENTS

In the following, only some example embodiments are briefly described. As a person skilled in the art can realize, the described embodiments may be modified in various different ways without departing from the spirit or scope of the present disclosure. Accordingly, the drawings and descriptions are to be regarded as illustrative and not restrictive in nature.

In the description of the present disclosure, it needs to be understood that the orientation or position relations denoted by such terms as "central" "longitudinal" "latitudinal" "length" "width" "thickness" "above" "below" "front" "rear" "left" "right" "vertical" "horizontal" "top" "bottom" "inside" "outside" "clockwise" "counterclockwise" and the like are based on the orientation or position relations as shown in the drawings, and are used only for the purpose of facilitating description of the present disclosure and simplification of the description, instead of indicating or suggesting that the denoted devices or elements must be oriented specifically, or configured or operated in a specific orientation. Thus, such terms should not be construed to limit the present disclosure. In addition, such terms as "first" and "second" are only used for the purpose of description, rather than indicating or suggesting relative importance or implicitly indicating the number of the denoted technical features. Accordingly, features defined with "first" and "second" may, expressly or implicitly, include one or more of the features. In the description of the present disclosure, "plurality" means two or more, unless otherwise defined explicitly and specifically.

In the description of the present disclosure, it needs to be noted that, unless otherwise specified and defined explicitly, such terms as "installation" "coupling" and "connection" should be broadly understood as, for example, fixed connection, detachable connection, or integral connection; or mechanical connection, electrical connection or intercommunication; or direct connection, or indirect connection via an intermediary medium; or internal communication between two elements or interaction between two elements. For those skilled in the art, the specific meanings of such terms herein can be construed in light of the specific circumstances.

Herein, unless otherwise specified and defined explicitly, if a first feature is "on" or "beneath" a second feature, this may cover direct contact between the first and second features, or contact via another feature therebetween, other than the direct contact. Furthermore, if a first feature is "on", "above", or "over" a second feature, this may cover the case that the first feature is right above or obliquely above the second feature, or just indicate that the level of the first feature is higher than that of the second feature. If a first feature is "beneath", "below", or "under" a second feature, this may cover the case that the first feature is right below or obliquely below the second feature, or just indicate that the level of the first feature is lower than that of the second feature.

The following disclosure provides various different embodiments or examples so as to realize different structures described herein. In order to simplify the disclosure herein, the following will give the description of the parts and arrangements embodied in specific examples. Of course, they are only for the example purpose, not intended to limit the present disclosure. Besides, the present disclosure may repeat a reference number and/or reference letter in different examples, and such repeat is for the purpose of simplification and clarity, which does not represent any relation among various embodiments and/or arrangements as discussed. In addition, the present disclosure provides examples of various specific processes and materials, but those skilled in the art can also be aware of application of other processes and/or use of other materials.

The preferred embodiments of the present disclosure will be introduced below with reference to the drawings. It should be appreciated that the preferred embodiments described here are only for the purpose of illustrating and explaining, instead of limiting, the present disclosure.

At present, a LiDAR typically adopts the solution of pulse coding to suppress interference. The basic idea of the pulse coding solution is that a LiDAR transmits a laser pulse containing a predetermined coding information to detect a target object; and identifies echoes through the predetermined coding when receiving echoes, so as to determine a reflected echo of a detection beam transmitted by this LiDAR.

The pulse coding can adopt one or more of coding schemes including time interval coding, peak intensity coding, pulse width coding, and so on. For example, if the time interval coding is adopted, a plurality of laser pulses containing time coding information are transmitted. Preferably, dual laser pulses with a predetermined time interval are transmitted, and based on a time interval of a pulse echo, it is determined at a receiving end whether this echo is a reflected echo of a detection beam transmitted by this LiDAR. Furthermore, the two laser pulses having the predetermined time interval may have the same or different pulse energies, which means that dual laser pulses with different energies can be transmitted.

Further, for example, if the peak intensity coding is adopted, a plurality of laser pulses containing peak intensity coding information are transmitted. Preferably, three laser pulses having a variation trend of "high-short-high" in peak intensity are transmitted, and based on a ratio of peak intensities of a pulse echo (the peak intensities of the pulse echo will attenuate compared to a transmitted pulse, but the ratio remains basically constant and a certain tolerance can be set), it is determined at a receiving end whether this pulse echo is a reflected echo of a detection beam transmitted by this LiDAR.

Further, for example, if the pulse width coding is adopted, a plurality of laser pulses containing pulse width coding information are transmitted. Preferably, three laser pulses having a variation trend of "wide-narrow-wide" in pulse width are transmitted, and based on a ratio of pulse widths of a pulse echo (the echo's pulse width may be widened compared to a transmitted pulse, but the ratio remains basically constant and a certain tolerance can be set), it is determined at the receiving end whether this pulse echo is a reflected echo of a detection beam transmitted by this LiDAR.

However, if the solution of pulse coding is used, this means that a plurality of laser pulses need to be transmitted within one detection. In consideration of the safety of human eye, a total energy of pulses transmitted by a LiDAR during each detection is limited.

Using the solution of pulse coding requires allocating the pulse energy available within one detection to a plurality of laser pulses, and this will affect respective amplitudes/pulse widths of the plurality of laser pulses. Compared to the solution of only transmitting a single pulse within one detection, the energy obtainable in each pulse is lower when the solution of pulse coding is adopted, thereby reducing the long-range detection performance of the LiDAR.

A preferred embodiment of the present disclosure provides a control method for a LiDAR, which, as much as possible, increases the energy of a long-range detection pulse and compresses the base of the energy of a short-range detection pulse under the premise of meeting the safety requirements for human eye, enabling laser pulses carrying coding information to have more excellent long-range detection performance and achieve the anti-crosstalk effect during short-range detection at the same time. The long-range detection performance and anti-crosstalk function of the LiDAR are weighed to achieve a maximally beneficial application of pulse energy.

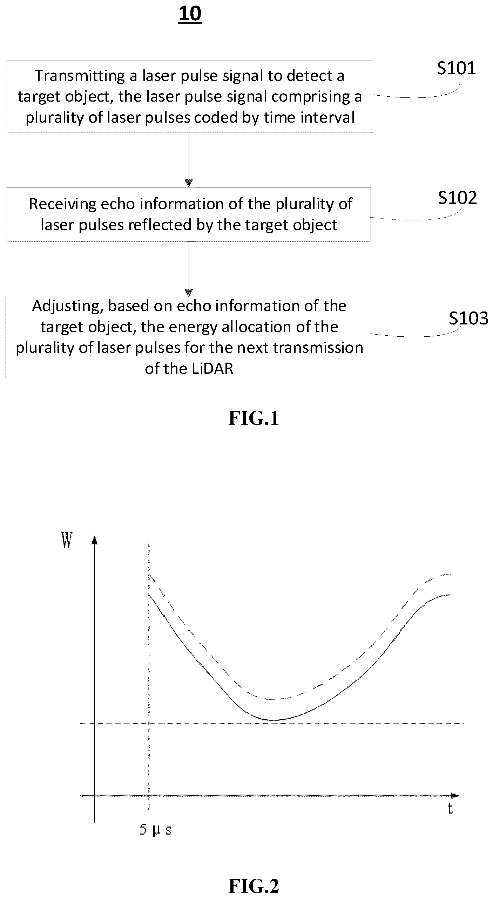

According to one preferred embodiment of the present disclosure, as shown in FIG. 1, the present disclosure provides a control method 10 for a LiDAR, comprising steps S101, S102, and S103.

In the step S101, a laser pulse signal is transmitted based on a pulse coding and a current energy allocation scheme to detect a target object, and the laser pulse signal comprises a plurality of laser pulses adopting this pulse coding. This pulse coding can adopt one or more of the time interval coding, peak intensity coding, and pulse width coding as mentioned above. The premise of the energy allocation scheme is that a sum of the energy of transmitted pulses is less than a safety threshold for human eye.

FIG. 2 schematically shows a curve of change of a safe laser power for human eye over time (which may vary due to different wavelengths, repetition frequencies, irradiation angles, and irradiation duration, namely, this curve of change may vary for different types of LiDARs). Since a sum of time of pulses transmitted within one detection is much less than 5 µs, it is therefore only necessary to consider that a sum of the energy of the pulses transmitted within one detection is less than a safe energy threshold for human eye within 5 µs (integrating the safe laser power for human eye under the curve shown in FIG. 2). Those skilled in the art can understand that FIG. 2 is only one schematic form of a curve for the safe laser power for human eye corresponding to a LiDAR, while actual transformation of the safe power for human eye may generate different curves based on different dimensions of evaluation standards and/or different types, structures, performances and other aspects of the LiDAR.

In step S102, echo information of the plurality of laser pulses reflected by the target object is received. The effectiveness of an echo pulse is determined based on whether the echo pulse carries the same coding information as the transmitted pulse.

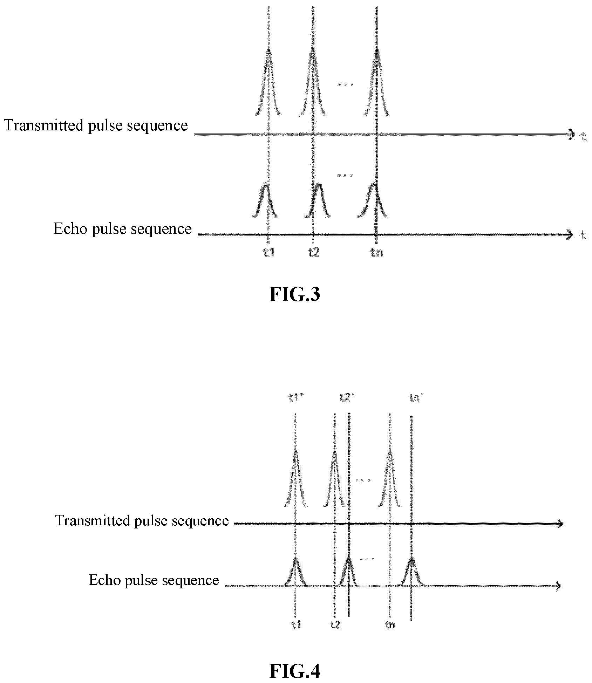

According to one embodiment of the present disclosure, as shown in FIG. 3, when a time sequence of an echo pulse sequence is the same as that of the transmitted pulse sequence, this echo pulse sequence is determined to be an echo signal of the transmitted pulse sequence, this signal is retained, and information carried by this signal is extracted.

According to another embodiment of the present disclosure, as shown in FIG. 4, when a time sequence of the echo pulse sequence is different from that of the transmitted pulse sequence, this echo pulse sequence is determined to be an echo signal of the pulse sequence transmitted by other LiDARs, and this echo pulse sequence is discarded.

Those skilled in the art can easily understand that coding and identification based on peak intensity or pulse width, or coding by using one or more of time interval, peak intensity, and pulse width, also falls within the scope of protection of the present disclosure.

In the step S103, an energy allocation scheme adopted for the next transmission of the LiDAR is updated based on the echo information of the target object. A distance from the target object and the effectiveness of the echo pulse are determined based on the echo information of the target object, and the energy allocation scheme is adjusted based on the distance from the target object and/or the effectiveness of the echo pulse to achieve the best long-range detection performance on the premise of meeting the safety requirements for human eye, while ensuring the anti-interference performance within a certain distance range.

When the solution of multi-pulse coding is adopted, relatively consistent ranging capabilities are typically maintained for various detection pulses in the prior art, that is, a plurality of laser pulses with similar energy are transmitted. Therefore, small pulses (detection pulses with relatively low energy or power) tend to be the bottleneck for the long-range detection performance of a LiDAR.

However, in fact, the demands for a LiDAR in terms of long-range and short-range detections are different. During long-range detection, it is necessary to consider the long-range detection capability, hoping that it can achieve a detection distance as far as possible. This requires that the laser pulse should have relatively high energy during long-range detection; and the probability of crosstalk taking place during the long-range detection is relatively low at the same time. While during short-range detection, the performance of large pulses (detection pulses with relatively high energy or power) is not prominent, especially subject to the factor of self-saturation of the detector; and the probability of crosstalk taking place at short range increases. Therefore, in practice, it is only necessary to provide anti-crosstalk coding for a short-range detection; a distance range of the current target object, or a current ranging condition of the LiDAR, is determined based on the echo information of the target object, and then the energy allocation of the laser pulses is adjusted based on the distance range of the target object / ranging condition.

According to one preferred embodiment of the present disclosure, in the control method 10, a sum of the energy of the plurality of laser pulses transmitted within a time for one detection is less than a first energy threshold, wherein the first energy threshold is determined based on the requirement that a sum of the energy of pulses transmitted within a predetermined time is less than the safety threshold for human eye.

Specifically, based on the safety requirements for human eye, the total energy of laser pulses transmitted by the LiDAR during multiple detections within a predetermined time period needs to be less than a safety threshold for human eye. In which the predetermined time period and the corresponding safety threshold for human eye vary depending on different detection manners and different performances of the LiDAR.

For example, within the same time period, the total energy that can be used by a LiDAR adopting a mechanical rotary scanning detection manner can be relatively high, because it will perform rotary scanning during the detection process, rather than remaining fixed in one direction; while the energy that can be allowed for a LiDAR adopting an area array flash detection manner is relatively low, because it is oriented toward a specific direction, and so on.

Generally, this predetermined time period is a microsecond-level temporal range, such as around 5 µs. Typically speaking, the time necessarily spent by a LiDAR during one detection ranges from tens of nanoseconds to hundreds of nanoseconds. That is to say, the time for one detection of the LiDAR is less than the predetermined time period.

For a particular LiDAR, since the time spent by one detection is definite, a sum of the energy of pulses available in each detection can be determined, that is, a sum of the energy of a plurality of laser pulses transmitted in one detection can be determined. For example, since a sum of time of pulses transmitted within one detection is much less than 5 µs, it thus can be directly considered that a sum of the energy of the pulses transmitted within one detection is less than the safety threshold for human eye within 5 µs.

Moreover, according to one preferred embodiment of the present disclosure, in the control method 10, the plurality of laser pulses transmitted in one detection comprises at least one long-range detection pulse and at least one short-range detection pulse. The transmission sequence of the at least one long-range detection pulse and the at least one short-range detection pulse is not limited, but the energy/power of the short-range detection pulse should not be greater than the energy/power of the long-range detection pulse.

Preferably, when there are a plurality of, for example three or more, coded pulses of different amplitudes, the pulse with the highest energy can be taken as the long-range detection pulse, while the remaining at least two pulses can be taken as the short-range detection pulses, so as to maximize the ranging capability.

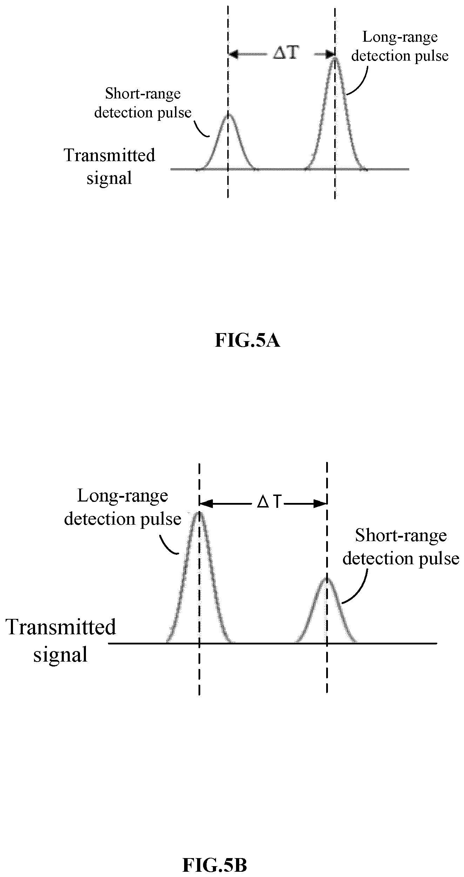

According to one preferred embodiment of the present disclosure, as shown in FIGS. 5A and 5B, one short-range detection pulse and one long-range detection pulse encoded by time interval are transmitted, wherein the transmission sequence of the short-range detection pulse and long-range detection pulse is not limited. In addition to adopting the time interval coding, peak intensity and pulse width can also be adopted for coding, or a combination of multiple coding schemes such as time interval, peak intensity, and pulse width can be adopted for coding. These all fall within the scope of protection of the present disclosure.

For the convenience of discussion, the solution of transmitting dual pulses with time interval coding is now taken as an example. The step S103 of the control method 10 further comprises: determining a ranging condition based on the echo information of the target object, and increasing the energy of the long-range detection pulse when the ranging condition is a long-range detection condition.

Preferably, when at least one of the following conditions is met, it is determined that the LiDAR is currently in the long-range detection condition:
(1) The target object is located beyond a first distance range, for example, beyond 80 meters. At this point, the requirement for the long-range detection performance of the LiDAR has increased, and the demand for anti-crosstalk has decreased. Among others, the first distance can be adjusted based on actual situations and demands. Typically speaking, the first distance range is used to indicate an area where relatively good ranging performance can be obtained solely based on a long-range detection pulse;
   and/or
(2) An echo of the short-range detection pulse as received is relatively weak, or no echo of the short-range detection pulse is received. At this point, there may be multiple reasons, such as the target object being located beyond the first distance range, and the energy of the short-range detection pulse being insufficient to detect this target object and is completely or almost completely attenuated; the low reflectivity of the target object; etc.

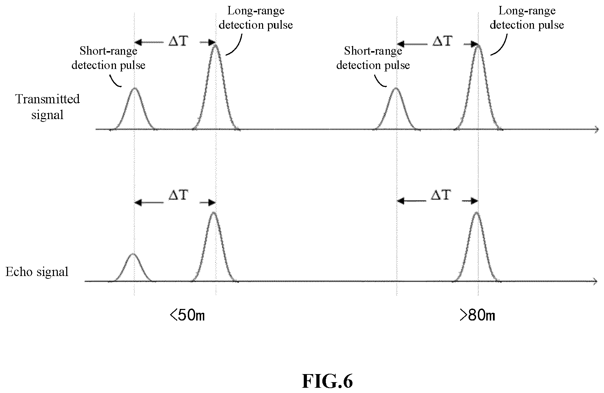

As shown in FIG. 6, when the target object is located within a distance range of less than 50 meters, echoes of both the short-range detection pulse and the long-range detection pulse can be received by the LiDAR; and when the target object is located in a distance range of greater than 80 meters, the LiDAR can only receive an echo of the long-range detection pulse.

Therefore, under the long-range detection condition, it is necessary to increase the energy/power of the long-range detection pulse for the next detection to improve the long-range detection precision of the LiDAR.

According to one preferred embodiment of the present disclosure, when the ranging condition is the long-range detection condition, the energy of the long-range detection pulse is increased, while the energy of the short-range detection pulse is decreased, the energy of the short-range detection pulse being greater than a second energy threshold. Among others, the second energy threshold is determined by the basic demand of the LiDAR for anti-interference performance.

Due to the limitation as mentioned above that the sum of the energy of the plurality of laser pulses within one detection must be less than the first energy threshold, in order to further increase the energy of the long-range detection pulse, it can be achieved by decreasing the energy of the short-range detection pulse. Under the long-range detection condition, if the target object is located beyond the first distance range (e.g., 80 meters), the requirements for the long-range detection performance will increase, the demand for the anti-crosstalk function will decrease, and the energy of the short-range detection pulse can be appropriately decreased. And/or, if an echo of the short-range detection pulse is relatively weak, or no echo of the short-range detection pulse is received, the short-range detection pulse cannot play a practical role in obtaining a distance from the target object, and thus the energy of the short-range detection pulse can also be appropriately decreased. The limitation of the energy of the short-range detection pulse is determined by the basic anti-crosstalk demand of the LiDAR, namely, when the target object appears within the second distance range (e.g., 50 meters), the demand for the anti-crosstalk function of the LiDAR will increase, and the requirement for the long-range detection performance will decrease. In this case, the LiDAR is still required to be capable of detecting and distinguishing a reflected echo of a detection beam transmitted by this LiDAR.

According to one preferred embodiment of the present disclosure, the long-range detection condition includes the target object being located beyond the first distance range (e.g., 80 meters), and the second energy threshold is determined based on the detection demand for the second distance range (e.g., 50 meters). Those skilled in the art can easily understand that the first distance range is 80 meters and the second distance range is 50 meters in this preferred embodiment, but such a technical solution that the first distance range is set to be less than or equal to the second distance range based on actual detection needs is also feasible. These all fall within the scope of protection of the present disclosure.

The energy limitation of the short-range detection pulse is that detection can still be performed within the second distance range. The second distance range is a range where the LiDAR has a relatively high anti-crosstalk demand. For example, within a range of 50 meters from this LiDAR, an echo signal corresponding to a detection beam transmitted by this LiDAR may be affected by other LiDARs mounted on this vehicle, or by a LiDAR mounted on a nearby vehicle. The first distance range is a range where the LiDAR has a relatively high requirement for long-range detection performance, for example, within a range of 80 meters from this LiDAR, the long-range detection condition includes determining that the target object is beyond the first distance range based on the echo information.

According to one preferred embodiment of the present disclosure, in the control method 10, when the ranging condition is the long-range detection condition, the energy of the long-range detection pulse is increased gradually for each detection until the sum of the energy of the plurality of laser pulses approaches the first energy threshold, and the energy of the short-range detection pulse therein is not lower than the second energy threshold. Among others, the first energy threshold is determined based on the safety threshold for human eye, and the second energy threshold is determined based on the basic demand of the LiDAR for anti-interference performance. That is, the energy allocation schemes are switched stepwise.

For example, the first energy threshold determined based on the safety threshold for human eye is 800 nJ, and the second energy threshold determined based on the basic anti-interference demand of the LiDAR is 100 nJ. The energy allocation scheme for the dual-pulse detection solution adopting time interval coding is shown in the table below.

**Table 1**

| Pulse Coding | Energy of Long-range Detection pulse | Energy of Short-range Detection pulse |
|---|---|---|
| PCode1 | 300nJ | 300nJ |
| PCode2 | 400nJ | 300nJ |
| PCode3 | 500nJ | 300nJ |
| PCode4 | 600nJ | 200nJ |
| PCode5 | 700nJ | 100nJ |

Predetermining that PCode1 is adopted for coding, when the ranging condition is determined to be the long-range detection condition based on the echo information, the energy of the long-range detection pulse will be increased by 100 nJ for the next detection, which means switching to PCode2; when the ranging condition is determined still to be the long-range detection condition based on the echo information, the energy of the long-range detection pulse will be increased by 100 nJ for the next detection, which means switching to PCode3, and at this point, a sum of the energy of the dual pulses has reached the first energy threshold (during the actual detection process, based on energy consumption and other considerations, the upper limit of the sum of the energy of the dual pulses can be set near, but not beyond, the first energy threshold, e.g., 750 nJ); when the ranging condition is determined still to be the long-range detection condition based on the echo information, the energy of the long-range detection pulse will be increased by 100 nJ for the next detection, while the energy of the short-range detection pulse will be decreased by 100 nJ, which means switching to PCode4; when the ranging condition is determined still to be the long-range detection condition based on the echo information, the energy of the long-range detection pulse will be increased by 100 nJ for the next detection, while the energy of the short-range detection pulse will be decreased by 100 nJ, which means switching to PCode5, and at this point, the energy of the short-range detection pulse has dropped to the second energy threshold; if the ranging condition is determined still to be the long-range detection condition based on the echo information, PCode5 will be continuously adopted for detection during the next detection; and if, within any one detection, the ranging condition is determined to be the short-range detection condition based on the echo information (i.e., in the case where a target object may exist at a short range), then the coding can be switched back to PCode1... wherein the long-range detection condition includes:
(1) Ranging information obtained within a predetermined time is located beyond the first distance range (e.g., 80 meters). A distance from the target object is calculated based on the echo information, and the ranging information obtained within the predetermined time indicates that the target object is located beyond the first distance range; and/or
(2) A received echo of the short-range detection pulse is relatively weak, or no echo of the short-range detection pulse is received; and/or
(3) In some cases, when the optical axis of the LiDAR is oriented at a certain angle (e.g., facing the straight-ahead direction of the traveling vehicle). The demand for detection precision will increase in the straight-ahead direction of the traveling vehicle, and the crosstalk situation of surrounding vehicles will be improved in the straight-ahead direction, thus the demand for anti-interference has relatively decreased.

To sum up, in the case of not exceeding the first energy threshold allowed by the safety of human eye, that is, in the case of maintaining the total energy constant, the allocation of the energy is adjusted between the short-range detection pulse and the long-range detection pulse to optimize detection results.

Among others, those skilled in the art can understand that by reasonably designing the circuit, the step size adjusted stepwise can be made larger or smaller. Even the effect of approximately stepless adjustment can be achieved. For example, by setting a resistance regulation module that can be varied approximately steplessly, stepless adjustment to the laser energy is achieved.

According to one preferred embodiment of the present disclosure, when the ranging condition is the long-range detection condition, the energy of the long-range detection pulse is increased for the next detection, so that the sum of the energy of the plurality of laser pulses approaches the first energy threshold, and the energy of the short-range detection pulse approaches the second energy threshold. Specifically, the term "approach" here is used to indicate a trend of energy adjustment, that is, the sum of the energy of the plurality of laser pulses after the adjustment is closer to the first energy threshold compared to the sum of the energy before the adjustment, and the energy of the short-range detection pulse after the adjustment is closer to the second energy threshold compared to the energy prior to the adjustment.

Among others, the first energy threshold is determined based on the safety threshold for human eye, for example, this first energy threshold can be calculated and obtained based on the safety standards of laser products in various countries or regions, as well as the types and detection modes of LiDAR products as actually used; and the second energy threshold is determined based on the basic demand of the LiDAR for anti-interference performance. That is, one-time switching is performed on the energy allocation scheme.

For example, the first energy threshold determined based on the safety threshold for human eye is 800 nJ, and the second energy threshold determined based on the basic anti-interference demand of the LiDAR is 100 nJ. The energy allocation scheme for the dual-pulse detection solution adopting time interval coding is shown in the table below.

**Table 2**

| | | |
|---|---|---|
| Pulse Coding | Energy of Short-range | Energy of Long-range |

| | Detection pulse | Detection pulse |
|---|---|---|
| PCode6 | 400nJ | 400nJ |
| PCode7 | 600nJ | 200nJ |

Predetermining that PCode6, as shown in Table 2, is adopted for coding, when the long-range detection condition is met, a switch to PCode7 is made. The long-range detection condition includes:
(1) The ranging information obtained within a predetermined time is located beyond the first distance range (e.g., 80 meters); and/or
(2) A received echo of the short-range detection pulse is relatively weak, or no echo of the short-range detection pulse is received; and/or
(3) In some cases, when the optical axis of the LiDAR is oriented at a certain angle (e.g., facing the straight-ahead direction of the traveling vehicle).

According to one preferred embodiment of the present disclosure, in the control method 10, the plurality of laser pulses comprises at least one long-range detection pulse and at least one short-range detection pulse, the step S103 further comprising:
determining a ranging condition based on the echo information of the target object, and decreasing the energy of the long-range detection pulse while increasing the energy of the short-range detection pulse when the ranging condition is the short-range detection condition, the energy of the short-range detection pulse being less than or equal to the energy of the long-range detection pulse in the same transmission.

Among others, the short-range detection condition includes:
(1) The ranging information obtained within the predetermined time is located within the second distance range (e.g., 50 meters). That is, a distance from the target object is calculated based on the echo information, and the ranging information obtained within the predetermined time indicates that the target object is located in an area near the LiDAR where crosstalk occurs frequently; and/or
(2) When the LiDAR's optical axis is not oriented at this certain angle (e.g., facing in a direction other than the straight-ahead direction of the traveling vehicle). In a detection direction other than the straight-ahead direction of the traveling vehicle, there exists mutual interference with a LiDAR mounted on a surrounding vehicle, and the energy of the short-range detection pulse should be increased to improve the short-range detection performance.

According to one preferred embodiment of the present disclosure, when the ranging condition is the short-range detection condition, the long-range detection pulse and the short-range detection pulse similar in energy are transmitted during the next detection, and the sum of the energy of the plurality of laser pulses is controlled to approach the first energy threshold. A dual-pulse sequence of similar energy coded by time interval is transmitted to achieve the optimal short-range detection performance (anti-crosstalk performance).

For example, the first energy threshold determined based on the safety threshold for human eye is 800 nJ, and the second energy threshold determined based on the basic anti-interference demand of the LiDAR is 100 nJ. In a dual-pulse detection solution adopting the time interval coding, the energy allocation scheme is shown in Table 2 above: PCode2 is adopted for coding currently, and when the short-range detection condition is met, it switches to PCode1.

According to one preferred embodiment of the present disclosure, the control method 10 further comprises:
adjusting the peak intensities or pulse widths of the plurality of laser pulses by adjusting the energy allocation of the plurality of laser pulses for the next transmission of the LiDAR.

Typically, when this LiDAR adopts the time interval coding, the peak intensities and/or pulse widths of the laser pulses can be adjusted to achieve the purpose of regulating the energy allocation. When this LiDAR adopts the peak intensity coding, the ratio of the peak intensities (variation trend) can be maintained constant, and the energy allocation can be regulated by adjusting the pulse widths. When this LiDAR adopts the pulse width coding, the ratio of the pulse widths (variation trend) can be maintained constant, and the energy allocation can be regulated by adjusting the peak intensities.

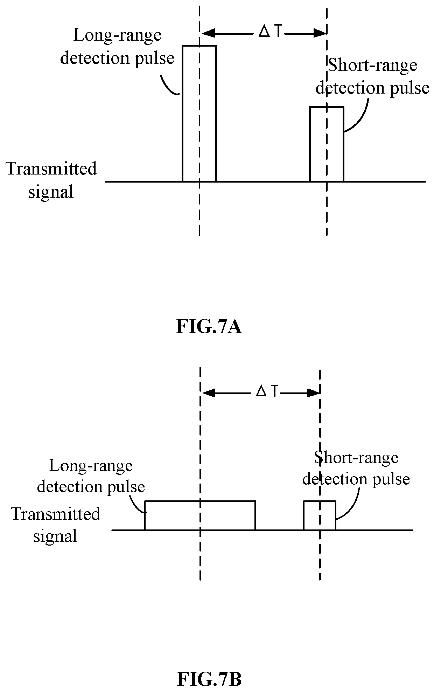

According to one preferred embodiment of the present disclosure, as shown in FIGS. 7A and 7B, a short-range detection pulse and a long-range detection pulse within the same detection can have the same or similar pulse time but different peak power (as shown in FIG. 7A), or can have the same or similar pulse peak power but different pulse time (as shown in FIG. 7B). For the embodiment shown in FIG. 7A, it is preferably applied to a multi-channel mechanical LiDAR, which improves the detection precision through a long-range detection pulse with relatively high peak power and suppresses crosstalk through the dual-pulse coding. For the embodiment shown in FIG. 7B, it is preferably applied to an area array flash solid-state LiDAR, which increases the probability of photon reception through a long-range detection pulse with relatively wide pulse width and suppresses crosstalk through the dual-pulse coding.

Specifically, the operation required at the time of peak intensity and/or pulse width regulation varies with the pulse coding scheme. For example, when only the time interval coding is adopted, there is no need to consider the ratio of the peaks or the ratio of the pulse widths of various pulses in an initial waveform, and then there is no need to regulate the detection end accordingly at the time of performing energy regulation; furthermore, for example, when the peak coding is adopted, and if various pulses in an initial waveform are the same in pulse width but different in peak, it is necessary to simultaneously update the energy allocation ratio on which various detection ends depend for verification at the time of changing the energy allocation, that is, the information on the allocation ratio used by a detection end for verification can be updated based on the regulation of the energy allocation; similarly, when the pulse width coding is adopted, various pulses in an initial waveform are different in pulse width and the same in peak, the allocation ratio information adopted by a detection end can also be updated accordingly at the time of performing energy allocation regulation.

According to one preferred embodiment of the present disclosure, a transmitting end of the LiDAR transmits a multi-pulse sequence adopting time interval coding and an energy allocation scheme. The multi-pulse sequence comprises, for example, a first laser pulse and a second laser pulse (one long-range detection pulse and one short-range detection pulse), and this is not of generality for sure; or it can also comprise a first laser pulse, a second laser pulse, ... and the N^{th} laser pulse, the plurality of laser pulses having a time sequence relationship. The above-mentioned time interval represents the time sequence relationship in the transmitted pulse sequence. After adjustment to the energy allocation scheme, a receiver unit can still determine a reflected echo of the transmitted pulse sequence transmitted by this LiDAR by verifying the time sequence relationships of the echo pulse sequence and the transmitted pulse sequence.

According to another preferred embodiment of the present disclosure, the transmitter unit of the LiDAR transmits a multi-pulse sequence adopting peak intensity coding and an energy allocation scheme, wherein the energy allocation scheme comprises: decreasing the energy of the short-range detection pulse and increasing the energy of the long-range detection pulse in the case where a long-range detection mode is met. Continue to explain the solution of this embodiment. This multi-pulse sequence comprises one long-range detection pulse and one short-range detection pulse, with the peak energy ratio of 1.2:1 between the long-range detection pulse and the short-range detection pulse. Correspondingly, a detector end determines whether a received pulse is a pulse of the LiDAR to which the detector end belongs based on whether a peak energy ratio of two pulses consecutively received satisfies 1.2:1.

Subsequently, when the current mode in one detection is found to be the long-range detection mode, the energy of the short-range detection pulse is decreased by 50%, and this 50% energy is then added to the long-range detection pulse. At this point, the peak energy ratio of the long-range detection pulse to the short-range detection pulse can be 1.7:0.5, namely 3.4:1, and the peak energy ratio of echo pulses, on which the determination of the detector end is based, is updated to 3.4:1 accordingly. Subsequently, the transmitting end transmits a long-range detection pulse and a short-range detection pulse based on the new energy allocation ratio scheme, and the detector end determines whether a received echo is the correct echo pulse based on this new energy allocation ratio.

According to another preferred embodiment of the present disclosure, the transmitter unit of the LiDAR transmits a multi-pulse sequence adopting pulse width coding and an energy allocation scheme. This multi-pulse sequence comprises one strong pulse and one weak pulse, with a pulse width ratio of 2:1, namely a pulse width of the strong pulse is twice that of the weak pulse. Correspondingly, the detector end determines whether received pulses are pulses of the LiDAR to which it belongs based on whether the pulse width ratio of two pulses consecutively received satisfies 2:1.

Subsequently, when the current mode in one detection is found to be the long-range detection mode, the energy of the short-range detection pulse is thus decreased, and the energy of the long-range detection pulse is increased, so that the pulse width ratio of the long-range detection pulse to the short-range detection pulse is 3:1, and the pulse width ratio of echo pulses, on which the determination of the detector end is based, is updated to 3:1 accordingly. Subsequently, the transmitting end transmits a long-range detection pulse and a short-range detection pulse based on the new energy allocation ratio scheme, and the detector end determines whether a received echo is the correct echo pulse based on this new energy allocation ratio.

Subsequently, the LiDAR continues to perform detection based on the new energy allocation ratio. When the current ranging information is found to be 46 meters in another detection, which belongs to the short-range detection mode, the energy of the long-range detection pulse is decreased while the energy of the short-range detection pulse is increased, so that the pulse width ratio of the long-range detection pulse to the short-range detection pulse is 1.5:1, thereby allowing for better utilization of the pulse coding of the long-range detection pulse and that of the short-range detection pulse to distinguish the pulses transmitted by this LiDAR.

As one more preferred solution, the long-range detection mode can involve multiple levels. For example, the long-range detection mode can be divided into a medium-to-long ranging (e.g., 50-100 meters) mode and an ultra-long ranging (e.g., greater than 100 meters) mode, and the detection end performs determination based on the new energy allocation ratio only in the medium-to-long ranging mode. In the ultra-long ranging mode, as long as an echo pulse is received, it is considered to be the echo pulse corresponding to the long-range detection pulse.

That is to say, in certain detection modes, such as the ultra-long ranging mode, the interference from other LiDARs or transmission sources is already minimal and can be ignored, and it is sufficient to only consider the pulses that can be received. At this point, the detector end can stop verifying the pulse coding.

As another preferred embodiment of this solution, when one long-range detection pulse and two or more short-range detection pulses are coded in one detection, a portion of the short-range detection pulses can be removed, the energy of that portion of the short-range detection pulses can be allocated to the long-range detection pulse, and the anti-crosstalk determination conditions adopted by the detector end can be regulated accordingly to make determination based on the pulse coding after energy reallocation.

For example, the LiDAR initially adopts triple-pulse coding, with a peak energy ratio of 1:2:3 among three pulses pulse1, pulse2, and pulse3, among which the one with the highest peak is the long-range detection pulse, and the other two are the short-range detection pulses. Meanwhile, the detector end needs to determine that this echo pulse belongs to this LiDAR when receiving three echo pulses with the ratio of energy of these three echo pulses being 1:2:3. When the LiDAR determines that the current mode is the long-range detection mode, the energy of the pulse pulse1 with the lowest energy is then allocated to the pulse pulse3 with the highest energy. That is, the LiDAR transmits a dual-pulse coding only in a peak energy ratio of 2:4, and updates the determination condition of the detector end to that two echo pulses are determined to belong to this LiDAR when the pulses with an energy ratio of 2:4 are received. On the contrary, at the time of entering the short-range detection mode from the long-range detection mode, transmission and detection are performed still based on the triple-pulse coding with the peak energy ratio of 1:2:3.

Similarly, when more pulses are encoded, a similar allocation manner can be adopted, so as to enhance the energy of the long-range detection pulse in the long-range detection mode and achieve better long-range detection performance.

More preferably, a certain tolerance can be set for the energy allocation of the long-range and short-range detection pulses. After adjustment to the energy allocation scheme, if the transmitting unit adjusts the energy allocation scheme by adjusting the pulse widths of the plurality of laser pulses, the receiving unit determines a predetermined ratio relationship of the pulse widths of the multi-pulse sequence as transmitted in this detection based on the energy allocation scheme updated by a control unit of the LiDAR, and then determines a reflected echo of the transmitted pulse sequence transmitted by this LiDAR by verifying the pulse width ratios of the echo pulse sequence and the transmitted pulse sequence, where a certain tolerance can be set.

As one preferred and alternative solution, in the case where there is a margin in the total energy in one detection, that is, the total energy transmitted in one detection is less than the safety threshold for human eye, the energy allocation scheme in the long-range detection can be to only increase the energy of the long-range detection pulse without decreasing the energy of the short-range detection pulse.

According to one preferred embodiment of the present disclosure, the control method 10 further comprises: increasing the pulse peaks of the plurality of laser pulses by increasing the maximum driving currents/voltages of the plurality of laser pulses.

The circuit can be implemented by multiple modes of implementation. For example, a voltage-regulatable driving circuit or a laser driving circuit containing a plurality of energy storage circuits can be adopted to regulate the energy of various pulses. Typically speaking, the current through a laser is proportional to the driving voltage applied to the laser and inversely proportional to the resistance of the circuit where the laser is located. Therefore, there are two major methods for regulating the current/voltage on the laser, one being to regulate the driving voltage, and the other being to regulate the resistance.

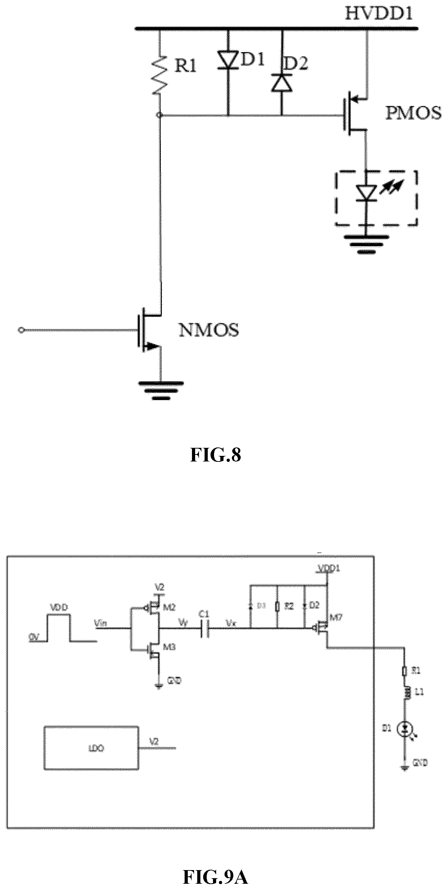

According to one preferred embodiment of the present disclosure, FIG. 8 illustrates a schematic diagram of the implementation of a circuit structure that can regulate the energy of a transmitted pulse by regulating the current on a laser.

Among others, the current of the laser shown in FIG. 8 is related to the applied voltage and resistance as follow:
Imax=HVDD1/(Rd+Rdson) where HVDD 1 is a driving voltage applied to the laser, Rd is an equivalent resistance of the laser itself, and Rdson is a total resistance of PMOS and other devices connected to the same. Therefore, there are two major methods for regulating Imax, one being to regulate the voltage HVDD1, and the other being to regulate the resistance Rdson.

On the basis of the regulatable circuit mentioned above, one controller module is integrated, which can switch between multiple sets of pulse coding, and can perform direct switching based on the two coding schemes above, or generate pulse control signals separately based on a stepwise regulated pulse coding and regulate the input voltage HVDD 1 or the resistance value Rdson through the pulse control signals so as to transmit corresponding laser pulses.

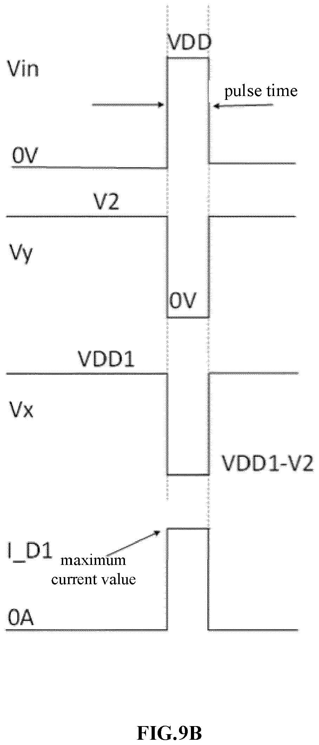

According to one preferred embodiment of the present disclosure, a time sequence diagram of the regulation circuit shown in FIG. 9A is shown in FIG. 9B. In this embodiment, the intensity of the current of the laser corresponds to the magnitude of the voltage Vx, and the Vx can be regulated by V2 output from a low-voltage linear low dropout regulator (LDO). When V2 increases, Vx decreases, and when V2 decreases, Vx increases. By controlling the LDO to output a corresponding V2, the current of the laser can be regulated, that is, the transmitted pulse can be regulated.

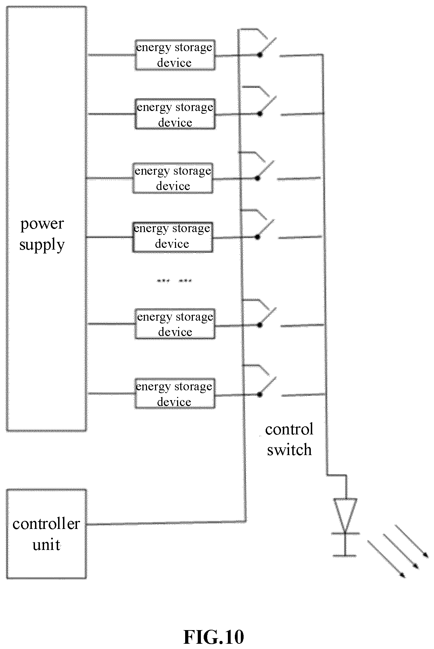

According to one preferred embodiment of the present disclosure, FIG. 10 illustrates one mode of implementation of a circuit adopting energy storage modules. As shown in FIG. 10, multiple energy storage modules are connected to a power supply module, each energy storage module being connected to one control switch responsible for controlling the on/off of the energy storage module and a laser transmitting unit. When the control switch between a certain energy storage module and the laser transmitting unit is closed, the charge stored in the energy storage module drives the laser transmitting unit to transmit light pulses. Specifically, various unit switches shown in FIG. 10 can be independent of each another, and the control switches are independently controlled by the control unit. At the same time along the timeline, the controller unit can control the control switches to be open or closed independently. When a plurality of control switches are closed at the same time, the energy of the transmitted laser pulses is a sum of the energy of several energy storage modules. By simultaneously closing the plurality of control switches at the same time to transmit high-energy pulses, detection of an object at a long range can be achieved. By controlling the number and time points of the control switches closed along the timeline, the shape of the pulses transmitted along the timeline can be controlled. For example, at a certain time when only one control switch is closed, the intensity of the pulse transmitted at this time is 1 unit, while at a subsequent time when N control switches are closed, the intensity of the pulses transmitted at the corresponding time is N units. By controlling the number of switches closed at different times through the control unit, the time sequence and intensity of a transmitted pulse can be controlled.

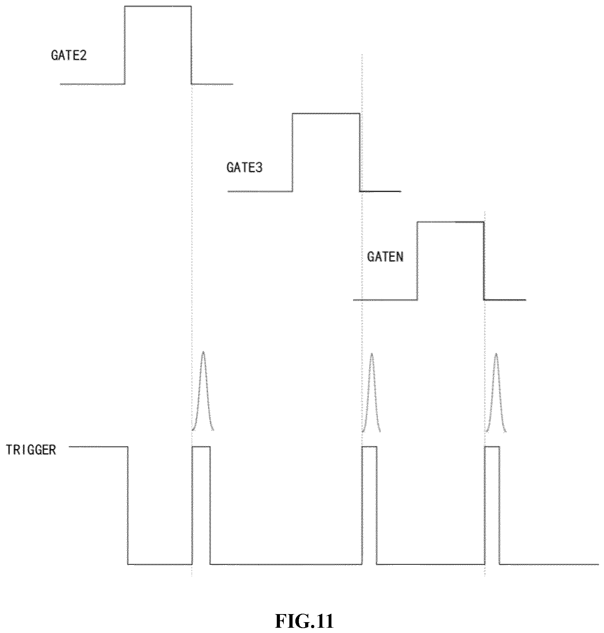

According to one preferred embodiment of the present disclosure, as shown in FIG. 11, a plurality of laser pulses having the same or similar pulse width but different peak power are obtained by controlling the transmission time of the plurality of laser pulses. When switch control signals (GATE1, GATE2... GATEN) end, a switch trigger signal (TRIGGER) is triggered. For example, a falling edge of the time sequence of the switch control signals (GATE1, GATE2... GATEN) shown in the figure triggers a falling edge of the switch trigger signal (TRIGGER); without loss of generality, if the end of the switch trigger signal (TRIGGER) corresponds to a rising edge of a time sequence signal, then this rising edge serves as the trigger timing for the switch control signal to ensure that the light transmitting process starts after the end of charging, and the next charging-transmitting process can immediately start after the end of the previous charging-transmitting process. In the embodiment shown in FIG. 11, the temporal widths among the switch control signals (GATE1, GATE2... GATEN) are equal, so as to ensure that various pulse widths in a pulse sequence as transmitted are basically consistent.

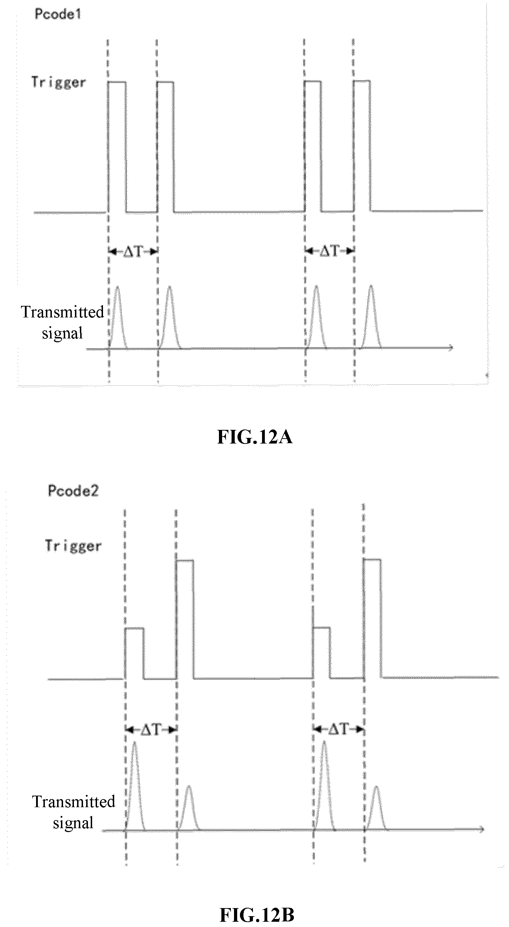

FIGS. 12A and 12B show that the PCode1 and PCode2 described previously are obtained under the triggering of the switch control signals.

According to one preferred embodiment of the present disclosure, the control method 10 further comprises:
maintaining the driving current/voltage constant, and extending/shortening the pulse widths of the plurality of laser pulses by extending/shortening the transmission time of the plurality of laser pulses. Then the plurality of laser pulses having the same or similar peak power but different pulse width are obtained as shown in FIG. 7B. The specific circuit implementation structure for adjusting the transmission time will not be repeated here.

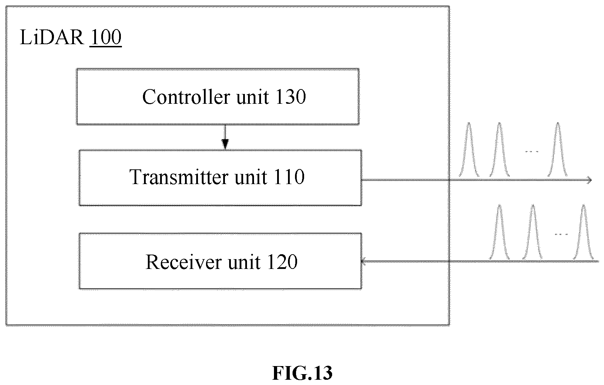

According to one preferred embodiment of the present disclosure, as shown in FIG. 13, the present disclosure further provides a LiDAR 100, comprising a transmitter unit 110, a receiver unit 120, and a controller unit 130.

The transmitter unit 110 transmits a laser pulse signal so as to detect a target object, the laser pulse signal comprising a plurality of laser pulses coded by time interval;
The receiver unit 120 is configured to receive echo information of the plurality of laser pulses reflected by the target object; and
The controller unit 130 is configured to adjust, based on the echo information of the target object, the energy allocation of the plurality of laser pulses for the next transmission of the LiDAR.

According to one preferred embodiment of the present disclosure, a sum of the energy of the plurality of laser pulses is less than a first energy threshold, the first energy threshold being determined based on the requirement that the total energy of pulses transmitted within a predetermined time is less than a safety threshold for human eye.

According to one preferred embodiment of the present disclosure, the plurality of laser pulses comprises at least one long-range detection pulse and at least one short-range detection pulse, and the controller unit 130 is further configured to:
determine a ranging condition based on the echo information of the target object, and increase the energy of the long-range detection pulse when the ranging condition is a long-range detection condition.

According to one preferred embodiment of the present disclosure, the controller unit 130 is further configured to:
increase the energy of the long-range detection pulse while decrease the energy of the short-range detection pulse when the ranging condition is the long-range detection condition, the energy of the short-range detection pulse being greater than a second energy threshold.

According to one preferred embodiment of the present disclosure, the long-range detection condition includes the target object being located beyond a first distance range, and the second energy threshold being determined based on the detection demand for a second distance range, the second distance range being less than or equal to the first distance range.

According to one preferred embodiment of the present disclosure, the transmitter unit 110 comprises at least one laser, and the LiDAR 100 further comprises:
a first energy regulator unit coupled with the at least one laser and the controller unit 130, and configured to regulate the driving current/voltage of the at least one laser under the control of the controller unit 130 to adjust the pulse peaks of the plurality of laser pulses for the next transmission of the LiDAR 100.

According to one preferred embodiment of the present disclosure, the transmitter unit 110 comprises at least one laser, and the LiDAR 100 further comprises:
a second energy regulator unit coupled with the at least one laser and the controller unit 130, and configured to regulate the transmission time of the at least one laser under the control of the controller unit 130 to adjust the pulse widths of the plurality of laser pulses for the next transmission of the LiDAR 100.

A preferred embodiment of the present disclosure provides a control method for a LiDAR, comprising: transmitting a plurality of laser pulses encoded by time interval and adjusting the energy allocation of the plurality of laser pulses during the next transmission based on echo information of a target object. The preferred embodiment of the present disclosure not only satisfies the anti-crosstalk demand within a short range, but also improves the detection precision and detection performance within a long range, and a maximally beneficial application of laser pulse energy is obtained while safety requirements for human eye are met.

Last but not least, it is noted that described above are just preferred embodiments of the present disclosure, which are not used to limit the present disclosure. Although the detailed description of the present disclosure has been provided with reference to the foregoing embodiments, those skilled in the art can still make modifications to the technical solution as recited in each of the foregoing embodiments, or conduct equivalent replacement of some technical features therein. Any modification, equivalent replacement, or improvement, if falling into the spirit and principles as stated herein, should be included in the scope of protection of the present disclosure.

## Claims

1. A control method for a LiDAR, comprising:
S101: transmitting a laser pulse signal based on a pulse coding and a current energy allocation scheme, to detect a target object, the laser pulse signal comprising a plurality of laser pulses adopting the pulse coding;
S102: receiving echo information of the plurality of laser pulses reflected by the target object; and
S 103: updating, based on the echo information of the target object, the energy allocation scheme adopted by the LiDAR for the next transmission.

2. The control method of claim 1, wherein a sum of the energy of the plurality of laser pulses is less than a first energy threshold, the first energy threshold being determined based on the requirement that the total energy of pulses transmitted within a predetermined time is less than a safety threshold for human eye.

3. The control method of claim 2, wherein the plurality of laser pulses comprises at least one long-range detection pulse and at least one short-range detection pulse, the step S103 further comprising:
determining a ranging condition based on the echo information of the target object, and increasing the energy of the long-range detection pulse when the ranging condition is a long-range detection condition.

4. The control method of claim 3, wherein the step S103 further comprises:
increasing the energy of the long-range detection pulse while decreasing the energy of the short-range detection pulse when the ranging condition is the long-range detection condition, the energy of the short-range detection pulse being greater than a second energy threshold.

5. The control method of claim 4, wherein the long-range detection condition includes the target object being located beyond a first distance range, and the second energy threshold is determined based on the detection demand for a second distance range, the second distance range being less than or equal to the first distance range.

6. The control method of any one of claims 3-5, wherein when the ranging condition is the long-range detection condition, the energy of the long-range detection pulse is increased stepwise for each detection until the sum of the energy of the plurality of laser pulses approaches the first energy threshold.

7. The control method of claims 4 or 5, wherein when the ranging condition is the long-range detection condition, the energy of the long-range detection pulse is increased for the next detection, so that the sum of the energy of the plurality of laser pulses approaches the first energy threshold, and the energy of the short-range detection pulse approaches the second energy threshold.

8. The control method of claim 2, wherein the plurality of laser pulses comprises at least one long-range detection pulse and at least one short-range detection pulse, the step S103 further comprising:
determining a ranging condition based on the echo information of the target object, and decreasing the energy of the long-range detection pulse while increasing the energy of the short-range detection pulse when the ranging condition is a short-range detection condition, the energy of the short-range detection pulse being less than or equal to the energy of the long-range detection pulse in the same transmission.

9. The control method of claim 8, wherein when the ranging condition is the short-range detection condition, the long-range detection pulse and the short-range detection pulse similar in energy are transmitted during the next detection, and the sum of the energy of the plurality of laser pulses is controlled to approach the first energy threshold.

10. The control method of any one of claims 1-5, 8, and 9, further comprising:
adjusting the peak intensities or pulse widths of the plurality of laser pulses by adjusting the energy allocation of the plurality of laser pulses for the next transmission of the LiDAR.

11. The control method of claim 10, further comprising:
increasing the pulse peaks of the plurality of laser pulses by increasing the maximum driving current/voltage of the plurality of laser pulses.

12. The control method of claim 10, further comprising:
maintaining the driving current/voltage constant, and extending/shortening the pulse widths of the plurality of laser pulses by extending/shortening the transmission time of the plurality of laser pulses.

13. The control method of any one of claims 1-5, 8, and 9, further comprising:
calculating a distance from the target object based on the echo information corresponding to the plurality of laser pulses.

14. A LiDAR, comprising:
a transmitter unit configure to transmit a laser pulse signal based on a pulse coding and a current energy allocation scheme, to detect a target object, the laser pulse signal comprising a plurality of laser pulses adopting the pulse coding;
a receiver unit configured to receive echo information of the plurality of laser pulses reflected by the target object; and
a controller unit configured to update, based on the echo information of the target object, the energy allocation scheme adopted by the LiDAR for the next transmission.

15. The LiDAR of claim 14, wherein a sum of the energy of the plurality of laser pulses is less than a first energy threshold, the first energy threshold being determined based on the requirement that the total energy of pulses transmitted within a predetermined time is less than a safety threshold for human eye.

16. The LiDAR of claim 15, wherein the plurality of laser pulses comprises at least one long-range detection pulse and at least one short-range detection pulse, and the controller unit is further configured to:
determine a ranging condition based on the echo information of the target object, and increase the energy of the long-range detection pulse when the ranging condition is a long-range detection condition.

17. The LiDAR of claim 16, wherein the controller unit is further configured to:
increase the energy of the long-range detection pulse while decrease the energy of the short-range detection pulse when the ranging condition is the long-range detection condition, the energy of the short-range detection pulse being greater than a second energy threshold.

18. The LiDAR of claim 17, wherein the long-range detection condition includes the target object being located beyond a first distance range, and the second energy threshold is determined based on the detection demand for a second distance range, the second distance range being less than or equal to the first distance range.

19. The LiDAR of any one of claims 14-18, wherein the transmitter unit comprises at least one laser, and the LiDAR further comprises:
a first energy regulator unit coupled with the at least one laser and the control unit, and configured to regulate the driving current/voltage of the at least one laser under the control of the controller unit to adjust the pulse peaks of the plurality of laser pulses for the next transmission of the LiDAR.

20. The LiDAR of any one of claims 14-18, wherein the transmitter unit comprises at least one laser, and the LiDAR further comprises:
a second energy regulator unit coupled with the at least one laser and the controller unit, and configured to regulate a transmission time of the at least one laser under the control of the controller unit to adjust the pulse widths of the plurality of laser pulses for the next transmission of the LiDAR.
